(19)

Europäisches
Patentamt
European
Patent Office
Office européen
des brevets

(11) **EP 0 961 126 B1**

(12) **EUROPEAN PATENT SPECIFICATION**

(45) Date of publication and mention
of the grant of the patent:
**09.01.2008 Bulletin 2008/02**

(51) Int Cl.:
***G01R 31/02*** *(2006.01)*

(21) Application number: **98830331.9**

(22) Date of filing: **29.05.1998**

(54) **Monitoring of low currents through a low-side driven DMOS by modulating its internal resistance**

Schwachstromüberwachung durch "low-side" getriebenen DMOS mittels Modulierung seines inneren Widerstands

Surveillance d'un courant faible à travers d'un DMOS "low-side" en utilisant la modulation de sa résistance interne

(84) Designated Contracting States:
**DE FR GB IT**

(43) Date of publication of application:
**01.12.1999 Bulletin 1999/48**

(73) Proprietor: **STMicroelectronics S.r.l.**
**20041 Agrate Brianza (Milano) (IT)**

(72) Inventors:
• **Gervasi, Luigi**
**27010 San Genesio ed Uniti (IT)**
• **Lecce, Sergio**
**27100 Pavia (IT)**

• **Cocetta, Franco**
**33040 Premariacco (IT)**
• **Merlo, Mauro**
**27020 Torre D'Isola (IT)**

(74) Representative: **Pellegri, Alberto et al**
**Società Italiana Brevetti S.p.A.**
**Via Avegno, 6**
**21100 Varese (IT)**

(56) References cited:
**EP-A- 0 419 093** **EP-A- 0 743 529**
**US-A- 5 079 456** **US-A- 5 164 659**
**US-A- 5 519 341**

EP 0 961 126 B1

Printed by Jouve, 75001 PARIS (FR)

**Description**

FIELD OF THE INVENTION

The present invention relates to power stages employing integrated DMOS transistors and in particular to a "low-side" driving stage of an external load.

BACKGROUND OF THE INVENTION

Integrated power stages and in particular "low-side" and "high-side" driving stages, constituted by an integrated power transistor that delivers a current to an external load are used in innumerable applications, as a reliable and cost effective alternative to classical electromechanical relays.

While an integrated DMOS transistor represent an extremely efficient device to switch relatively high powers, its integrity must be carefully safeguarded by preventing dangerous functioning conditions which may cause its failure.

Therefore it is a common practice to realize special circuits that monitor the conditions of operation to avert any accidental occurrence of illicit conditions.

In particular, a very important information for correctly enabling the switching of the integrated DMOS transistor of a low-side driver from a conduction state to an off state or viceversa is the one that exclude the existence of an "open load" condition. To do this, actuators in the form of integrated circuits using low-side drivers contain guard systems or sensing circuits capable of timely signalling an eventual open load condition.

Commonly, these circuits are required to detect whether an eventual open load state occurs during a phase in which the DMOS power transistor is off. This basic requisite of disabling the switching on of the transistor in case of open load is satisfactorily fulfilled by known circuits.

Although not generally required, sometimes it may be important to recognize an eventual open load condition also during a switched-on condition of the DMOS power transistor.

In case of a low-side driver, it is difficult to satisfy this type of requisite if the current level of discrimination between yet a conduction state that must be defined and recognized as an open load condition is established at a relatively low value, for example in the vicinity of 10-50 mA. Being the internal resistance, Rdson, of a conducting DMOS transistor about 0,5 Ohms and often even lower, a direct measurement of the current output by the transistor by monitoring its drain voltage becomes rather critical. Indeed, by assuming a discriminating threshold of 30 mA and a resistance Rdson=0.5 Ohms, a drain-source voltage (i.e. across the transistor's current terminals) $V_{DS}$=15mV would be available.

US-A-5,164,659 discloses low load condition discriminating and signalling circuits for a low side driver stage, based on the use of a comparator of the output voltage with a certain regulation voltage value, which as a consequence must be set slightly higher than the minimum allowable voltage level. In certain applications it may be penalizing not being able to regulate the output voltage to the minimum allowable level of load conditions.

US-A-5,079,456 describes a current sensing circuit for a low side driver based on the use of a transistor of fractional size through which a reference current flows generated by a current generator.

OBJECT AND SUMMARY OF THE INVENTION

The object of the present invention is to provide a method and a circuit that in general will permit to monitor relatively low currents through an integrated DMOS power transistor in a low-side driver configuration, in a simple and reliable manner.

Substantially, the method of the invention is based upon using a feedback circuit which, by acting on the voltage applied to the DMOS transistor's gate limits the minimum value to which the drain-source voltage ($V_{DS}$) may drop so to keep it sufficiently high and allow a reliable monitoring of the current through the transistor, even at relatively low levels. This is achieved by purposely modulating (increasing) the conduction resistance of the transistor Rdson at low current levels.

The method and the circuit of the invention are defined in claims 1 and 2 and particularly preferred embodiments are specified in the remaining claims annexed hereto.

BRIEF DESCRIPTION OF THE DRAWINGS

**Figure 1** is a diagram that shows the function of lowering the $V_{DS}$ voltage of an integrated DMOS transistor, at low current levels.

**Figure 2** is a basic diagram of the circuit for monitoring an open load condition, according to the present invention.

**Figure 3** shows a circuit for limiting the minimum value of the $V_{DS}$ voltage, at low current levels.

DESCRIPTION OF EMBODIMENTS

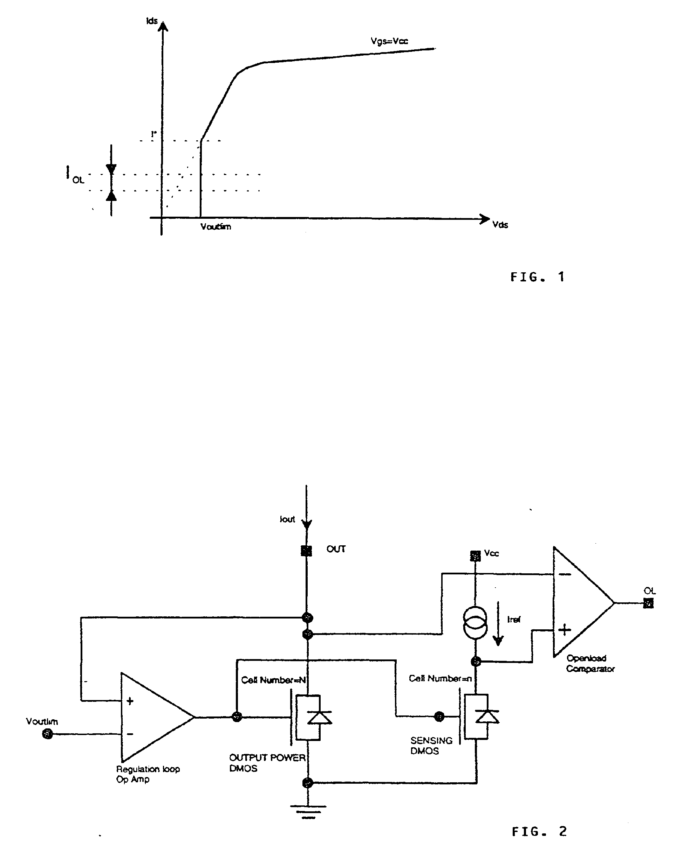

The diagram of figure 1 offers an immediate representation of the need or in any case of the opportunity of limiting to a certain minimum value the drop of the $V_{DS}$ voltage as sensed on the current terminals of an integrated DMOS power transistor constituting a low-side driver, in order to permit the monitoring of the current through the transistor even at particularly low levels in a reliable manner, even in case the imposed discrimination threshold is exceptionally low.

According to the invention, a basic scheme of the implementing circuit is shown in figure 2.

In the figure, beside the DMOS output power transistor itself, only the circuit elements that constitute the sensing system of the invention for an eventual open load condition are depicted.

The feedback loop is substantially constituted by an operational amplifier, REGULATION LOOP OP AMP, through which, according to the method of the invention, a modulation of the conduction resistance Rdson of the transistor is effected to limit to a minimum preestablished value, Voutlim, the voltage drop on the DMOS transistor, that is the $V_{DS}$ voltage of the transistor.

The monitoring of the current lout output by the DMOS transistor is done by the comparator, OPEN LOAD COMPARATOR, which compares the current lout with a reference current Iref, which is forced by the relative generator though an auxiliary DMOS transistor, typically smaller than the power transistor.

Both the power transistor and the auxiliary transistor are equally conditioned by the feedback loop that limits the minimum $V_{DS}$ voltage of the power transistor.

The practical realization of the feedback loop, functionally represented in the diagram of figure 2 by the operational amplifier, presents peculiar difficulties in the case of a low-side driver. These difficulties are mainly due to the high gain of the DMOS power amplifier in a common source configuration, during weak inversion conditions.

The situation is further complicated because, for recurrent application requirements, the output of the power transistor may be coupled to an external capacitance which may vary between 0 and 150 nF.

By referring to the basic scheme of figure 2, qualitatively, the method of the invention is based on the fact that, if the drain voltage $V_{DS}$ tends to drop below the fixed minimum value Voutlim, for example due to a drop of the output current, lout, the operational amplifier lowers the gate voltage of the DMOS power transistor so that its drain voltage will tend to increase.

When the drain voltage remains higher that the fixed minimum value Voutlim, the feedback loop has no effect because the operational amplifier saturates to the supply voltage Vcc, which is also the maximum gate voltage.

At this point, the sensing by the dedicated comparator OPEN LOOP COMPARATOR of a condition of open load may be effected by simply comparing the drain voltage of the power DMOS transistor, OUTPUT POWER DMOS, with the drain voltage of the reference (auxiliary) DMOS transistor, SENDING DMOS, through which is forced a certain reference current, Iref, by a dedicated current generator.

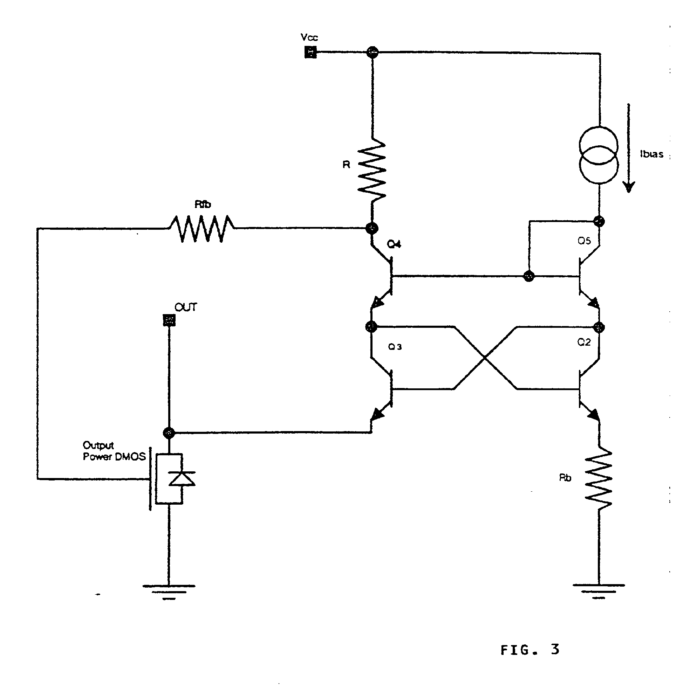

Figure 3 shows a particularly effective and reliable circuit of the feedback loop

Assuming that the pair of transistors Q4 and Q5, constituting a current mirror, have identical areas, the drain regulation voltage Voutlim (that may be fixed according to requirements) will be given by the equation

$$V_{OUTLIM} = V_T \ln\left(\frac{A_3}{A_2}\right) + I_{bias}R_b \qquad (1)$$

where $A_3$ and $A_2$ are the areas of the transistors Q3 and Q2, respectively, while the voltage $V_T$ represents the thermal voltage.

Equation (1) is obtained by neglecting all the base currents of the bipolar transistors that form the circuit of the feedback loop.

The value of the output current delivered by the OUTPUT POWER DMOS transistor that when reached the regulation loop will begin to regulate, that is to modulate the internal resistance of the transistor, is given by

$$I^* = \frac{V_{OUTLIM}}{R_{DSON}(V_{gs} = Vcc)} \qquad (2)$$

As far as the frequency response is concerned, the loop gain of the system presents two poles.
The loop gain at zero frequency may be expressed as

$$|A_0| = G_m R \qquad (3)$$

where $G_m$ is the transconductance of the power DMOS transistor.
The dominant pole is determined by the gate-source capacitance of the DMOS power transistor and is given by

$$P_d = \frac{1}{(R + R_{fb}) C_{gs-DMOS}} \qquad (4)$$

it is evident the stabilizing effect of Rfb and, therefore, the reason why this feedback resistor is introduced.
Being the second pole associated to the capacitance coupled to the drain of the DMOS, its position depends also from the capacitance of the externally connected load.
The low impedance level of the drain node ensures the stability of the system even in presence of an ample spread of external capacitance values.
The circuit includes an inner positive feedback loop due to the cross coupling of the transistors Q2 and Q3, which must be properly compensated. The function of the Rb resistance is to compensate such an internal loop, constituted by Q2 and Q3, by emitter degenerating Q2, thus reducing the gain of such an internal positive feedback loop.

**Claims**

1. A circuit for sensing an open load condition of a low-side driver constituted by an integrated DMOS transistor (Output Power DMOS) functionally connected between an external load and a ground node, during a switched on state of the transistor, comprising a feedback loop comprising an operational amplifier (REGULATION LOOP OP-AMP) having a non inverting input (+) coupled to the drain node of said first DMOS transistor (Output Power DMOS), an inverting input (-) coupled to a preestablished limiting voltage (Voutlim) and an output coupled to a gate node of said first DMOS transistor (Output Power DMOS) and of an auxiliary DMOS transistor (SENSING DMOS), and a comparator (OPEN LOAD COMPARATOR) having inputs (+, -) coupled to the drain node of said first DMOS transistor (Output Power DMOS) and to a reference signal, respectively,
wherein
said auxiliary DMOS transistor (SENSING DMOS) of fractional size compared to the size of said first DMOS transistor, co-integrated with their respective gates connected in common, through said auxiliary DMOS transistor (SENSING DMOS) flows a reference current (Iref) generated by a current generator connected between a supply node of the circuit and the drain of said auxiliary DMOS transistor (SENSING DMOS) for providing said reference signal to one input (+) of said comparator (OPEN LOAD COMPARATOR).

2. The circuit according to claim 1, **characterized in that** said amplifier includes
a first pair of transistors (Q2, Q3), cross-coupled to each other, the emitter of a first (Q3) transistor of said first pair being connected to the drain of said first DMOS (Output Power DMOS) and the emitter of the other transistor (Q2) of said first pair being connected through a degenerating resistor (Rb) to the ground node of the circuit, and a second pair of transistors (Q4, Q5), constituting a current mirror, the collector of the input branch transistor (Q5) of the mirror being coupled to a bias current generator (Ibias) connected to the power supply node (Vcc), while the collector (Q4) of the output branch transistor is connected, through a second resistor (R), to the power supply node (Vcc) and, through a third resistor (Rfb), to the common gate node of said first DMOS transistor (Output Power DMOS) and of said auxiliary DMOS transistor (SENSING DMOS); the difference between the base-emitter voltages ($\Delta V_{BE}$) of the

first pair of transistors (Q2, Q3) providing said lower limit voltage (Voutlim) of the drain-source voltage ($V_{DS}$) of said first DMOS transistor (Output Power DMOS).

3. The circuit of claim 3, wherein said transistors (Q2, Q3, Q4, Q5) of said two pairs are NPN bipolar junction transistors.

4. A low-side driver stage employing an integrated DMOS power transistor, **characterized in that** it comprises a sensing circuit of an open load state of the stage as defined in claim 1.

5. A method of monitoring the current output by a low-side driver composed of an integrated DMOS transistor (OUTPUT POWER DMOS), the gate voltage of which is controlled through a feedback circuit that limits to a fixed minimum level (Voutlim) the drain-source voltage ($V_{DS}$) of the transistor by increasing its internal resistance (Rdson) when such a minimum level (Voutlim) is surpassed, said method further comprising the step of comparing the current (Iout) output by said transistor with a reference fixed current (Iref) for producing a digital signal representative of a state of open or closed load, **characterized in that**

said reference current (Iref) is forced through an auxiliary transistor (SENSING DMOS) controlled by the same gate voltage of said DMOS transistor (OUTPUT POWER DMOS); and

the drain-source voltage ($V_{DS}$) of said DMOS transistor is compared with the drain-source voltage of said auxiliary transistor (SENSING DMOS) for producing said digital signal in function of said comparison.

**Patentansprüche**

1. Schaltung zur Abtastung eines Zustands ohne angeschlossene Last eines Low-Side-Treibers, der durch einen integrierten DMOS-Transistor (Output Power DMOS) gebildet wird, der funktionsfähig zwischen eine äußere Last und einen Masseknoten geschaltet ist, während eines Einschaltzustands des Transistors, der eine Rückkopplungsschleife aufweist, die einen Operationsverstärker (REGULATION LOOP OP-AMP) mit einem nicht-invertierenden Eingang (+) umfasst, der mit dem Drain-Knoten des ersten DMOS-Transistors (Output Power DMOS) verbunden ist, einen invertierenden Eingang (-), der mit einer vorher festgelegten Begrenzungsspannung (Voutlim) verbunden ist, und einen Ausgang, der mit einem Gate-Knoten des ersten DMOS-Transistors (Output Power DMOS) und eines Hilfs-DMOS-Transistors (SENSING DMOS) verbunden ist, und einen Komparator (OPEN LOAD COMPARATOR) aufweist, der Eingänge (+, -) aufweist, die mit dem Drain-Knoten des ersten DMOS-Transistors (Output Power DMOS) bzw. mit einem Bezugssignal verbunden sind, wobei

der Hilfs-DMOS-Transistor (SENSING DMOS) im Vergleich zur Größe des ersten DMOS-Transistors einen Bruchteil der Größe aufweist, die mit ihren jeweiligen Gates miteinander integriert sind, die gemeinsam verbunden sind, durch den Hilfs-DMOS-Transistor (SENSING DMOS) ein Bezugsstrom (Iref) fließt, der durch einen Stromgenerator erzeugt wird, der zwischen einem Versorgungsknoten der Schaltung und dem Drain-Anschluß des Hilfs-DMOS-Transistors (SENSING DMOS) geschaltet ist, zur Lieferung des Bezugssignals an einen Eingang (+) des Komparators (OPEN LOAD COMPARATOR).

2. Schaltung nach Anspruch 1, **dadurch gekennzeichnet, daß** der Verstärker aufweist:

ein erstes Paar Transistoren (Q2, Q3), die miteinander über Kreuz verbunden sind, wobei der Emitter eines ersten (Q3) Transistors des ersten Paars mit dem Drain-Anschluß des ersten DMOS (Output Power DMOS) verbunden ist und der Emitter des anderen Transistors (Q2) des ersten Paars durch einen Gegenkopplungswiderstand (Rb) mit dem Masseknoten der Schaltung verbunden ist, und ein zweites Paar Transistoren (Q4, Q5), die einen Stromspiegel bilden, wobei der Kollektor des Eingangszweigtransistors (Q5) des Spiegels mit einem Vorstromgenerator (Ibias) verbunden ist, der mit dem Stromversorgungsknoten (Vcc) verbunden ist, während der Kollektor (Q4) des Ausgangszweigtransistors durch einen zweiten Widerstand (R) mit dem Stromversorgungsknoten (Vcc) und durch einen dritten Widerstand (Rfb) mit dem gemeinsamen Gate-Knoten des ersten DMOS-Transistors (Output Power DMOS) und des Hilfs-DMOS-Transistors (SENSING DMOS) verbunden ist;

wobei die Differenz zwischen den Basis-Emitter-Spannungen ($\Delta V_{BE}$) des ersten Paars Transistoren (Q2, Q3) die untere Begrenzungsspannung (Voutlim) der Drain-source-Spannung ($V_{DS}$) des ersten DMOS-Transistors (Output Power DMOS) bereitstellt.

3. Schaltung nach Anspruch 3, wobei die Transistoren (Q2, Q3, Q4, Q5) der beiden Paare bipolare NPN-Sperrschichttransistoren sind.

4. Low-Side-Treiberstufe, die einen integrierten DMOS-Leistungstransistor einsetzt, **dadurch gekennzeichnet, daß** sie eine Abtastschaltung für einen Zustand ohne angeschlossene Last der Stufe aufweist, wie im Anspruch 1 definiert.

5. Verfahren zum Überwachen der Stromabgabe durch einen Low-Side-Treiber, der aus einem integrierten DMOS-Transistor (Output Power DMOS) besteht, dessen Gate-Spannung durch eine Rückkopplungsschaltung gesteuert wird, die die Drain-Source-Spannung ($V_{DS}$) des Transistors auf einen festen Minimalpegel (Voutlim) begrenzt, indem sein Innenwiderstand (Rdson) erhöht wird, wenn ein solcher Minimalpegel (Voutlim) übertroffen wird, wobei das Verfahren ferner den Schritt des Vergleichens des Stroms (Iout), der durch den Transistor abgegeben wird, mit einem festen Bezugsstrom (I-ref) aufweist, zum Erzeugen eines Digitalsignals, das für einen Zustand ohne angeschlossene Last oder mit angeschlossener Last repräsentativ ist, **dadurch gekennzeichnet, daß** der Bezugsstrom (Iref) durch einen Hilfstransistor (SENSING DMOS) erzwungen wird, der durch dieselbe Gate-Spannung des DMOS-Transistors (Output Power DMOS) gesteuert wird; und die Drain-Source-Spannung ($V_{DS}$) des DMOS-Transistors mit der Drain-Source-Spannung des Hilfstransistors (SENSING DMOS) verglichen wird, um das Digitalsignal als Funktion des Vergleichs zu erzeugen.

## Revendications

1. Circuit de détection d'un état de charge ouverte d'un amplificateur à charge à la haute tension constitué d'un premier transistor DMOS (Output Power DMOS) intégré connecté fonctionnellement entre une charge externe et un noeud de masse pendant un état de fermeture du transistor, comprenant une boucle de réaction comprenant un amplificateur opérationnel (REGULATION LOOP OP-AMP) ayant une entrée non inverseuse (+) couplée au drain du premier transistor DMOS (Output Power DMOS), une entrée inverseuse (-) couplée à une tension de limitation prédéterminée (Voutlim) et une sortie couplée à un noeud de grille du premier transistor DMOS (Output Power DMOS) et d'un transistor DMOS auxiliaire (Sensing DMOS), et un comparateur (OPEN LOAD COMPARATOR) ayant des entrées (+, -) couplées au noeud de drain du premier transistor DMOS (Output Power DMOS) et à un signal de référence, respectivement, dans lequel : le transistor DMOS auxiliaire (Sensing DMOS) de dimension fractionnaire par rapport à la dimension du premier transistor DMOS, cointégré avec leurs grilles respectives interconnectées par l'intermédiaire du transistor DMOS auxiliaire (Sensing DMOS), laisse passer un courant de référence (Iref) produit par un générateur de courant connecté entre un noeud d'alimentation et le circuit du drain du transistor DMOS auxiliaire (Sensing DMOS) pour fournir le signal de référence à une entrée (+) du comparateur (OPEN LOAD COMPARATOR).

2. Circuit selon la revendication 1, **caractérisé en ce que** l'amplificateur comprend :

   une première paire de transistors (Q2, Q3) inter-couplés, l'émetteur d'un premier transistor (Q3) de la première paire étant connecté au drain du premier transistor DMOS (Output Power DMOS) et l'émetteur de l'autre transistor (Q2) de la première paire étant connecté par l'intermédiaire d'une résistance de dégénération (Rb) au noeud de masse du circuit et une seconde paire de transistors (Q4, Q5) constituant un miroir de courant, le collecteur du transistor de branche d'entrée (Q5) du miroir étant couplé à un générateur de courant de polarisation (Ibias) connecté au noeud d'alimentation (Vcc), tandis que le collecteur (Q4) du transistor de branche de sortie est connecté, par l'intermédiaire d'une seconde résistance (R) au noeud d'alimentation (Vcc) et, par l'intermédiaire d'une troisième résistance (Rfb), au noeud de grille commun du premier transistor DMOS (Output Power DMOS) et du transistor DMOS auxiliaire (Sensing DMOS) ;
   la différence entre les tensions base-émetteur ($\Delta V_{BE}$) de la première paire de transistors (Q2, Q3) fournissant la tension limite inférieure (Voutlim) de la tension drain-source ($V_{DS}$) du premier transistor DMOS (Output Power DMOS).

3. Circuit selon la revendication 1, dans lequel les transistors (Q2, Q3, Q4, Q5) des deux paires sont des transistors bipolaires à jonction NPN.

4. Etage amplificateur à charge à la haute tension utilisant un transistor DMOS de puissance, **caractérisé en ce qu'**il comprend un circuit de détection d'un état de boucle ouverte de l'étage tel que défini en revendication 1.

5. Procédé de surveillance du courant de sortie d'un amplificateur à charge à la haute tension constitué d'un premier transistor DMOS (Output Power DMOS) intégré dont la tension de grille est commandée par l'intermédiaire d'un circuit de réaction qui limite à un niveau minimum fixe (Voutlim) la tension drain-source ($V_{DS}$) du transistor en augmentant sa résistance interne (Rdson) quand ce niveau minimum (Voutlim) est dépassé, ce procédé comprenant en outre l'étape consistant à comparer le courant (Iout) fourni par le transistor à un courant de référence fixe (Iref) pour produire un signal numérique représentatif d'un état de charge ouverte ou fermée, **caractérisé en ce que** :

le courant de référence (Iref) est forcé à travers un transistor auxiliaire (Sensing DMOS) commandé par la même tension de grille que le transistor DMOS (Output Power DMOS) ; et

la tension drain-source ($V_{DS}$) du transistor DMOS est comparée à la tension drain-source du transistor auxiliaire (Sensing DMOS) pour produire le signal numérique en fonction de ladite comparaison.

FIG. 1

FIG. 2

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5164659 A
- US 5079456 A